# EUROPEAN PATENT APPLICATION

(11) **EP 2 395 265 A1**
(43) Date of publication of application: **14.12.2011**
(21) Application number: 10738614.6
(22) Date of filing: 05.02.2010
(51) Int. Cl.: F16J 13/02, B01J 3/00

(54) **VACUUM DEVICE**

(30) Priority: 06.02.2009 JP 2009026418
(71) Applicant: Sharp Kabushiki Kaisha, Osaka-shi, Osaka 545-8522 (JP)
(72) Inventor: OZAKI, Yusuke, Osaka-shi, Osaka 545-8522 (JP); KISHIMOTO, Katsushi, Kyoto 619-0232 (JP); TANIGAWA, Nobuyuki, Osaka-shi, Osaka 545-8522 (JP); FUKUOKA, Yusuke, Osaka-shi, Osaka 545-8522 (JP)
(74) Representative: Müller - Hoffmann & Partner
(86) International application number: PCT/JP2010/051703
(87) International publication number: WO 2010/090283

(57) **Abstract**

A vacuum chamber (20) has an opening. A door (22) is to close the opening. A first rail (31) extends in a first direction with a space between the first rail and the opening when viewed in a planar view. Further, the first rail (31) supports the door (22) to be movable in the first direction. Further, the first rail (31) has a portion facing the opening in a second direction crossing the first direction when viewed in a planar view. Furthermore, the first rail has a first movable portion (31 M) movable in the second direction.

## Description

### TECHNICAL FIELD

The present invention relates to a vacuum device, in particular, a vacuum device having a vacuum chamber.

### BACKGROUND ART

A vacuum device including a load lock chamber and the like has a vacuum chamber having an opening for taking in and taking out a workpiece such as a substrate; and a door for closing the opening. The door is provided to be opened and closed.

According to Japanese Patent Laying-Open No. 9-199293 (Patent Document 1), such a door is connected to the main body (vacuum chamber) via a hinge.

Further, according to Japanese Patent Laying-Open No. 10-303277 (Patent Document 2), a door opening/closing mechanism has upper/lower driving mechanisms.

### PRIOR ART DOCUMENTS

### PATENT DOCUMENTS

Patent Document 1: Japanese Patent Laying-Open No. 9-199293
Patent Document 2: Japanese Patent Laying-Open No. 10-303277

### SUMMARY OF THE INVENTION

### PROBLEMS TO BE SOLVED BY THE INVENTION

According to the art described in Japanese Patent Laying-Open No. 9-199293, the door may be inclined due to gravity relative to the hinge as a fulcrum. Further, according to the art described in Japanese Patent Laying-Open No. 10-303277, large force is required to move the door against the gravity. These problems are more noticeable when the door has a large weight.

In view of these, one object of the present invention is to provide a vacuum device capable of stably supporting a door. Another object of the present invention is to provide a vacuum device allowing the door to be opened/closed with small force.

### MEANS FOR SOLVING THE PROBLEMS

A vacuum device of the present invention includes a vacuum chamber, a door, and a first rail. The vacuum chamber has an opening. The door is for closing the opening. The first rail extends in a first direction with a space between the first rail and the opening when viewed in a planar view. Further, the first rail supports the door to be movable in the first direction. Furthermore, the first rail has a portion facing the opening in a second direction crossing the first direction when viewed in a planar view. The first rail has a first movable portion movable in the second direction.

According to the vacuum device of the present invention, the door is supported by the rail. Hence, the door can be supported stably.

Preferably in the vacuum device, each of the first and second directions crosses a direction of gravity.

Accordingly, force required to move the door can be reduced.

Preferably, the vacuum device further includes a first driving portion for moving the first movable portion.

Accordingly, the first driving portion is driven with the door being supported by the first movable portion. Hence, the door can be moved in the second direction and be put on the opening.

Preferably, the vacuum device further includes a second driving portion for moving the door in the first direction.

Accordingly, the door can be moved in the first direction to come closer to or go farther away from the opening.

Preferably in the vacuum device, the second driving portion is attached to the door to define a position of the door in the first direction and to render a position of the door free in the second direction.

Accordingly, the movement of the door in the second direction is not prevented by the second driving portion.

Preferably in the vacuum device, the first rail has a taper portion tapered upward to have a size in the second direction getting smaller toward its tip. Further, the door has a portion sandwiching the taper portion in the second direction.

Accordingly, the position of the door in the second direction is stabilized.

Preferably, the vacuum device further includes a second rail. The second rail extends in the first direction with a space between the second rail and the opening when viewed in a planar view. Further, the second rail has a portion facing the opening in the second direction when viewed in a planar view. Furthermore, the second rail guides the door in the first direction. The second rail has a second movable portion movable in the second direction.

Accordingly, the movement of the door is regulated not only by the first rail but also by the second rail, thus preventing the door from being inclined around the first rail.

### EFFECTS OF THE INVENTION

As described above, according to the present invention, the door can be supported stably.

### BRIEF DESCRIPTION OF THE DRAWINGS

Fig. 1 is a perspective view schematically showing a configuration of a vacuum device in a first embodiment of the present invention, to show a fully opened state thereof.
Fig. 2 is a perspective view schematically showing the configuration of the vacuum device in the first embodiment of the present invention, to show a closed state thereof
Fig. 3 is a perspective view schematically showing a configuration of a vacuum device of a comparative example.
Fig. 4 is a front view schematically showing a configuration of a vacuum device in a second embodiment of the present invention, to show a fully opened state thereof.
Fig. 5 is a plan view schematically showing the configuration of the vacuum device in the second embodiment of the present invention, to show the fully opened state thereof.
Fig. 6 is a front view schematically showing the configuration of the vacuum device in the second embodiment of the present invention, to show a half-opened state thereof
Fig. 7 is a plan view schematically showing the configuration of the vacuum device in the second embodiment of the present invention, to show the half-opened state thereof.
Fig. 8 is a schematic cross sectional view taken along a line VIII-VIII in each of Fig. 6 and Fig. 7.
Fig. 9 is a plan view schematically showing the configuration of the vacuum device in the second embodiment of the present invention, to show a closed state thereof.
Fig. 10 is a schematic cross sectional view taken along a line X-X in Fig. 9.
Fig. 11 is a cross sectional view schematically showing a configuration of a vacuum device in a third embodiment.
Fig. 12 is a functional block diagram schematically showing the configuration of the vacuum device in the third embodiment.
Fig. 13 is a front view showing a conveying mechanism of the device of Fig. 11 and a workpiece.
Fig. 14 is a schematic cross sectional view taken along a line XIV-XIV of Fig. 11.
Fig. 15 is a cross sectional view schematically showing a first step of a vacuum processing method employing the device of Fig. 11.
Fig. 16 is a cross sectional view schematically showing a second step of the vacuum processing method employing the device of Fig. 11.
Fig. 17 is a cross sectional view schematically showing a third step of the vacuum processing method employing the device of Fig. 11.
Fig. 18 is a cross sectional view schematically showing a fourth step of the vacuum processing method employing the device of Fig. 11.
Fig. 19 is a plan view schematically showing a configuration of a vacuum device in a fourth embodiment.

### MODES FOR CARRYING OUT THE INVENTION

The following describes embodiments of the present invention with reference to figures. It should be noted that arrows x, y, and z in each figure represent a three-dimensional orthogonal coordinate system xyz in which the z direction corresponds to a direction opposite to the direction of gravity.

### (First Embodiment)

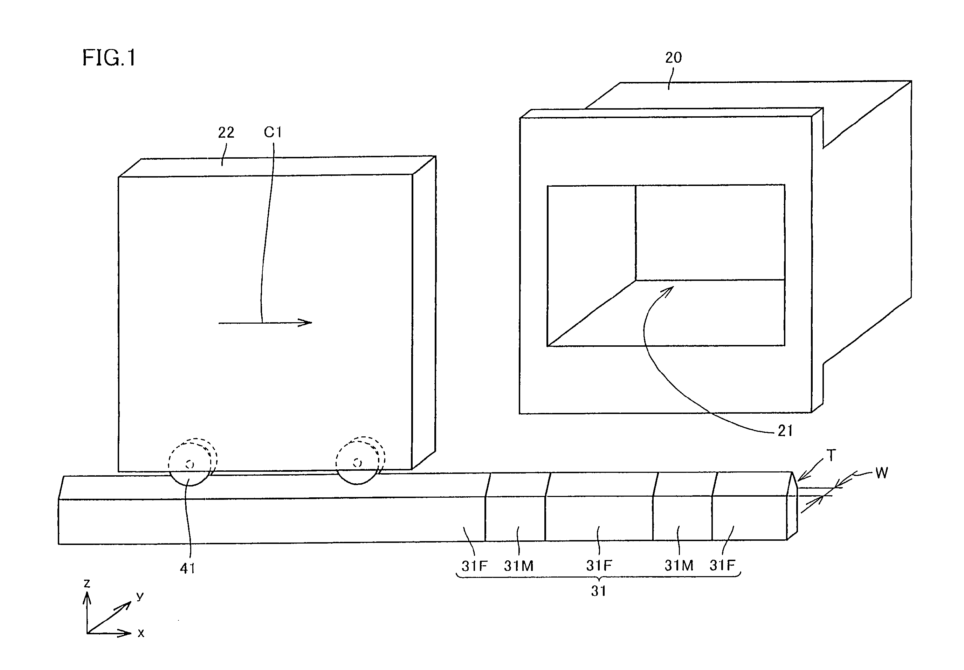

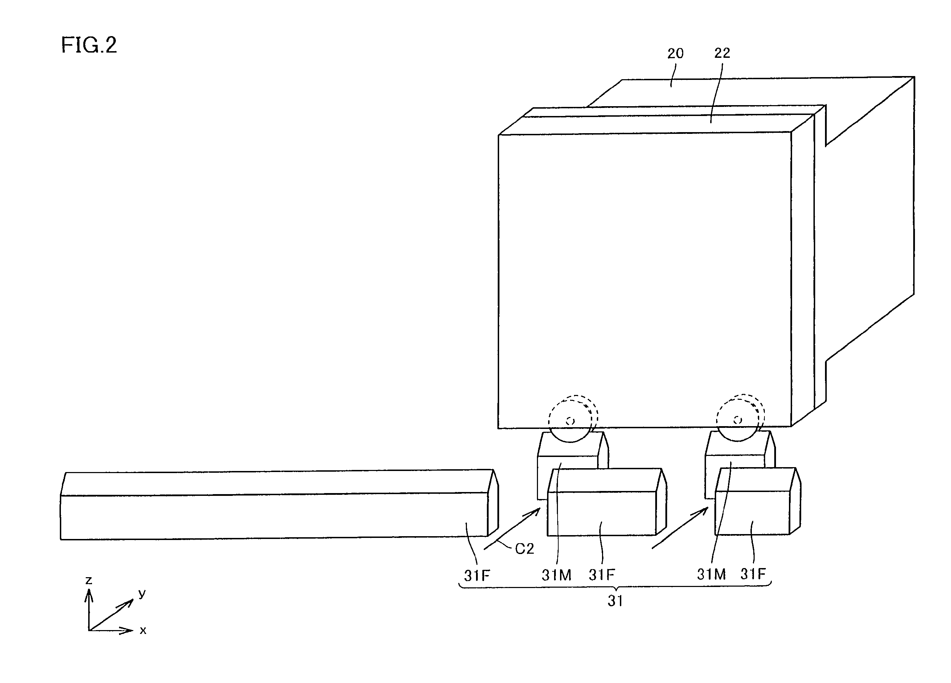

Referring to Fig. 1 and Fig. 2, a vacuum device of the present embodiment has a vacuum chamber 20, a door 22, and a supporting rail 31 (first rail).

Vacuum chamber 20 has an opening 21 parallel to the zx plane. Vacuum chamber 20 is, for example, a load lock chamber having a plurality of stairstep portions (plurality of regions) therein. In each of the stairstep portions, a substrate is placed. This substrate is, for example, a glass substrate used in manufacturing a thin film solar cell or a display device. Such a glass substrate generally has a size larger than that of a silicon substrate used for semiconductor devices. In a mass-production process, a multiplicity of substrates need to be placed in vacuum chamber 20 at the same time. Accordingly, the size of opening 21 becomes large, with the result that door 22 has a large size and a large weight.

Door 22 is to close opening 21. Further, door 22 has a plurality of wheels 41 provided at shafts in the lower portion of door 22. The shafts extend in the y direction. Preferably, the plurality of wheels 41, 41 are provided at locations sandwiching the center of gravity of door 22 in the x direction.

Supporting rail 31 extends in the x direction (first direction) with a space between supporting rail 31 and opening 21 in the y direction, when viewed in a planar view (field of view in parallel with the xy plane). Further, supporting rail 31 supports door 22 to be movable in the x direction. Furthermore, when viewed in a planar view, supporting rail 31 has a portion that faces opening 21 in the y direction (second direction) crossing the x direction.

Further, supporting rail 31 has supporting rail fixing portions 31F and supporting rail movable portions 31M. Each of supporting rail fixing portions 31F is fixed to a floor on which the vacuum device is installed. Each of supporting rail movable portions 31M is configured to be movable in the y direction as indicated by arrows C2 (Fig. 2). Further, supporting rail 31 has a taper portion T tapered upward to have a size W in the y direction getting smaller toward its tip. This taper portion T is sandwiched between wheels 41 of door 22 in the y direction.

The following describes a method for closing door 22.

Referring to Fig. 1, first, as indicated by an arrow C1, door 22 is moved in the x direction. Accordingly, door 22 is moved to a location facing opening 21 in the y direction, and wheels 41 are placed on supporting rail movable portion 31M.

Referring to Fig. 2, as indicated by arrows C2, door 22 and supporting rail movable portion 31M are moved toward opening 21 in the y direction. In this way, door 22 closes opening 21. This movement is accomplished by applying force to at least one of door 22 and supporting rail movable portion 31M in the direction of arrows C2.

Door 22 can be opened by performing the above-described procedure in a reverse manner.

The following describes a comparative example.

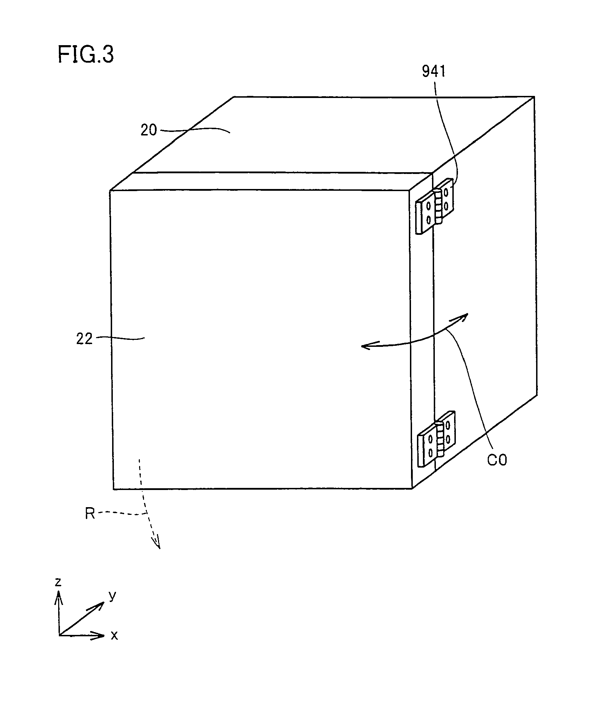

Referring to Fig. 3, a vacuum device of the comparative example is supported to be openable and closable by hinges 941 provided in door 22 at a right side portion thereof in the figure. In other words, the left side portion of door 22 in the figure is not supported by hinges 941. Accordingly, door 22 is likely to be inclined as indicated by a broken line arrow R.

If vacuum chamber 20 starts to be evacuated with door 22 thus being inclined, leakage between vacuum chamber 20 and door 22 may result in insufficient pressure reduction in vacuum chamber 20. If the inclination of door 22 is corrected using a method such as bolt fixing, the number of steps is increased.

According to the present embodiment, door 22 is supported by supporting rail 31. Hence, door 22 can be supported stably. In this way, door 22 can be prevented from being inclined.

Further, door 22 is not moved in the direction of gravity (z direction) but is moved in the x and y directions that cross the direction of gravity. This reduces force required to move door 22.

Further, wheels 41 of door 22 sandwich taper portion T therebetween in the y direction. Accordingly, the position of door 22 in the y direction is stabilized. Hence, opening 21 can be closed more securely.

### (Second Embodiment)

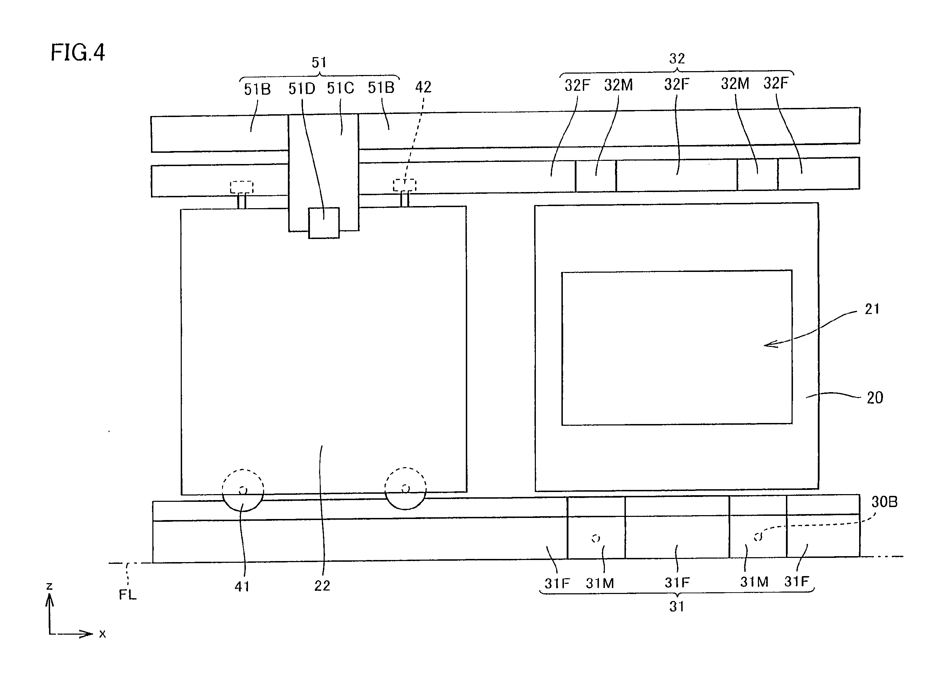

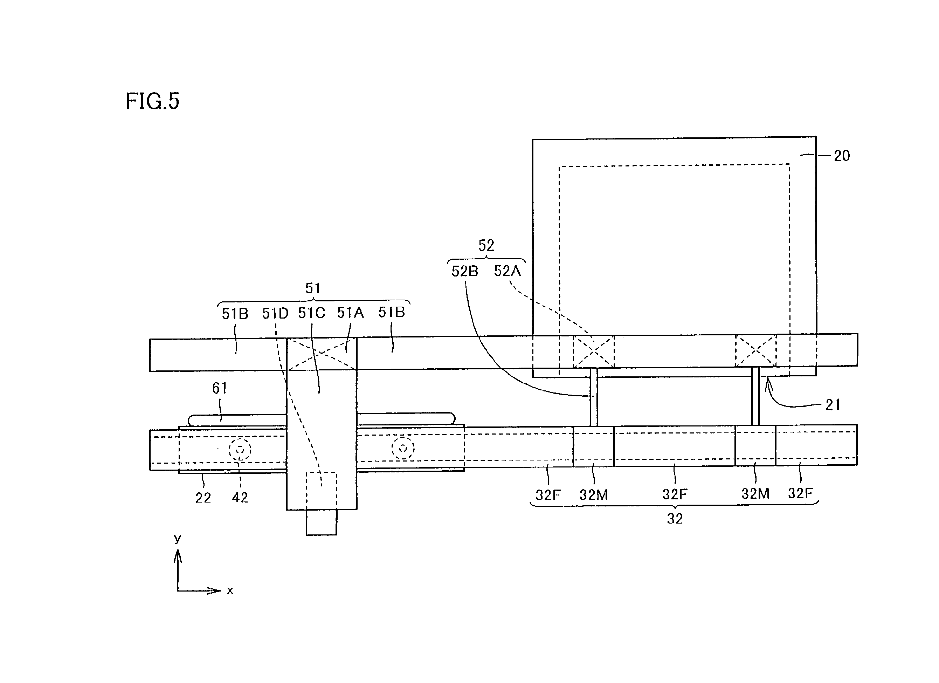

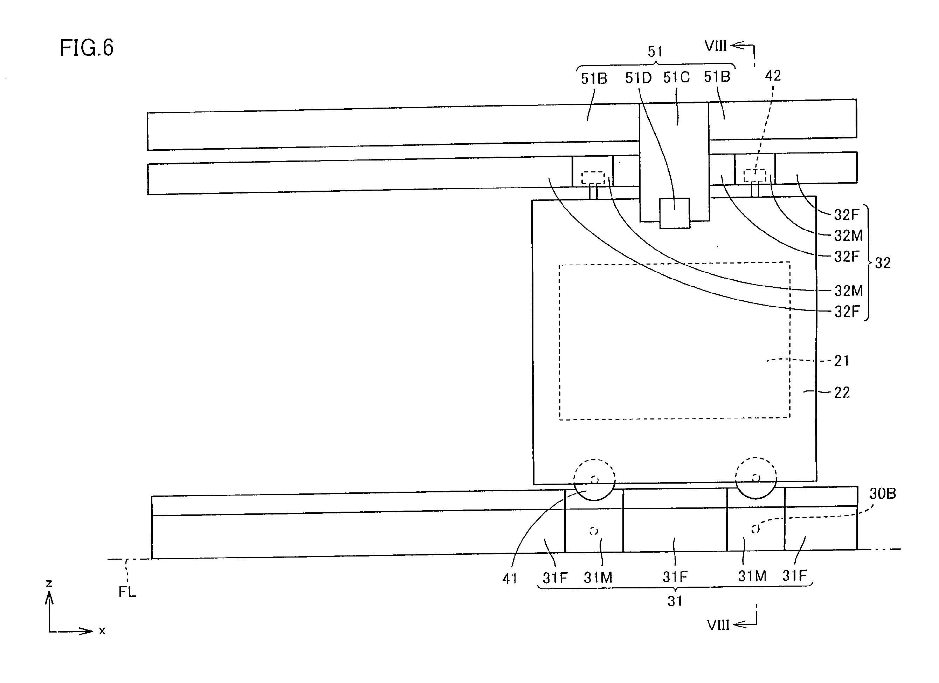

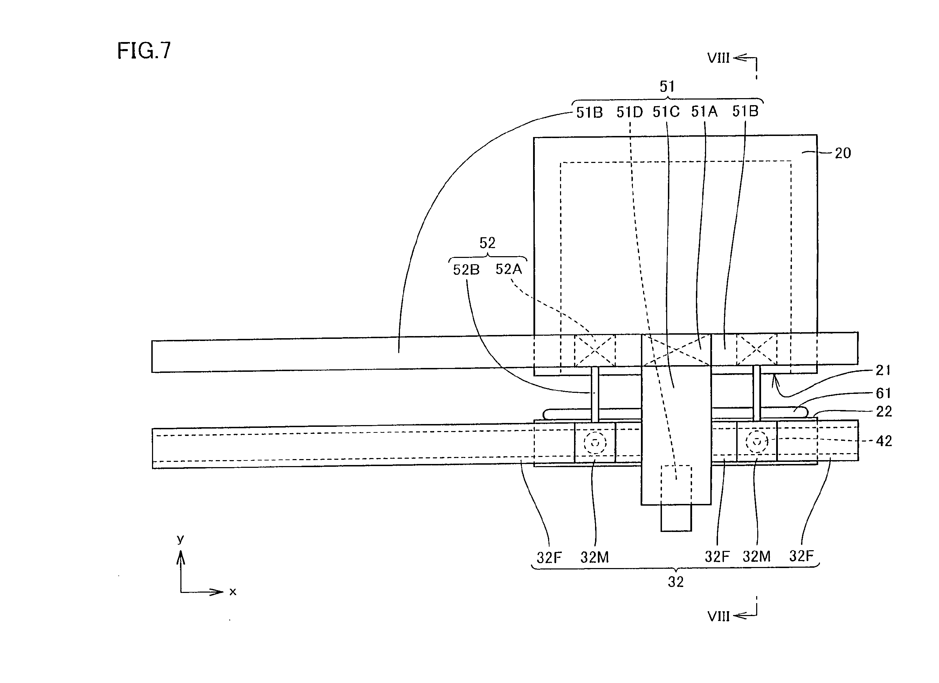

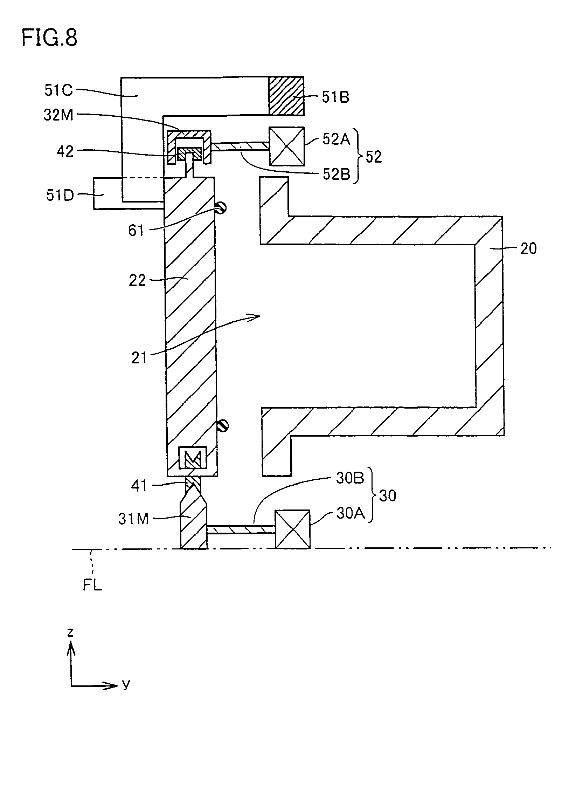

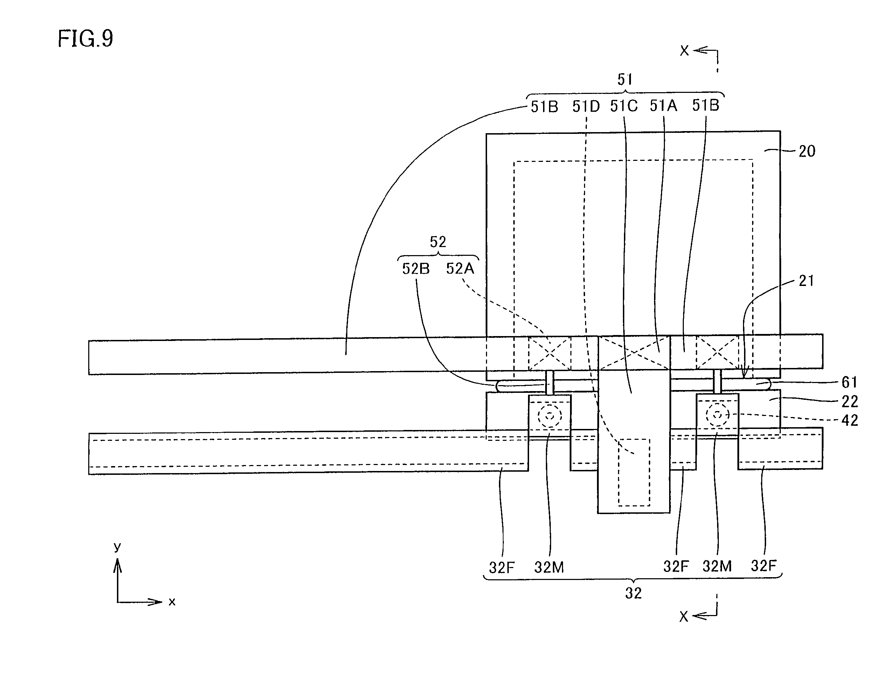

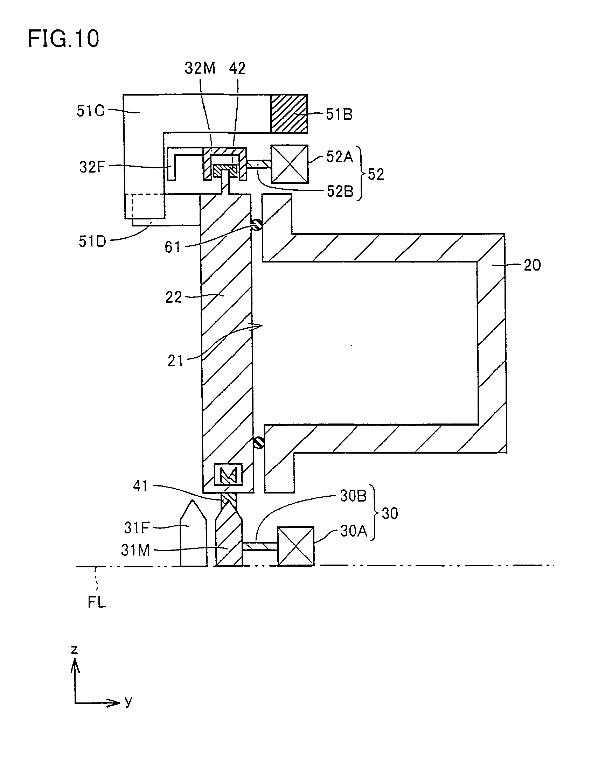

Referring to Fig. 4-Fig. 10, in addition to the configuration of the first embodiment, a vacuum device of the present embodiment includes: a supporting rail driving portion 30 (first driving portion); a door driving portion 51 (second driving portion); rollers 42; a guide rail 32 (second rail); guide rail driving portions 52; and an O ring 61.

Supporting rail driving portion 30 has a main body portion 30A, and rods 30B to be expanded and contracted by main body portion 30A. Main body portion 30A is fixed to a floor FL. Further, each of rods 30B extends in the y direction, and has its tip connected to supporting rail movable portions 31M. According to this configuration, supporting rail driving portion 30 can move supporting rail movable portions 31M in the y direction.

Door driving portion 51 has a displacement portion 51A, a raceway portion 51B, a holding portion 51C, and a projection 51D. Projection 51D is fixed to door 22, and is projected from door 22 in the y direction. Raceway portion 51B is provided to have a fixed position relative to floor FL, and extends in the x direction. Displacement portion 51A is configured to be driven along raceway portion 51B. Holding portion 51C has one end connected to displacement portion 51A. Holding portion 51C has the other end holding projection 51D in the x direction. Namely, door driving portion 51 is attached to door 22 to define a position of door 22 in the x direction and to render a position of door 22 free in the y direction. According to this configuration, door driving portion 51 can move door 22 in the x direction and does not prevent door 22 from being displaced in the y direction.

Each of rollers 42 has a shaft extending in the z direction, and is attached to the upper portion of door 22.

Guide rail 32 is fixed to floor FL using an appropriate fixing member, and has a portion that faces opening 21 in the y direction when viewed in a planar view. Further, when viewed in a planar view, guide rail 32 extends in the x direction with a space between guide rail 32 and opening 21. Further, guide rail 32 is configured to guide rollers 42, attached to door 22, in the x direction.

Further, guide rail 32 has guide rail fixing portions 32F and guide rail movable portions 32M (second movable portion). Each of guide rail movable portions 32M is configured to be movable in the y direction.

Each of guide rail driving portions 52 has a main body portion 52A and a rod 52B to be expanded and contracted by main body portion 52A. Main body portion 52A is fixed to floor FL. Further, rod 52B extends in the y direction, and has its tip connected to guide rail movable portion 32M. According to this configuration, guide rail driving portion 52 can move guide rail movable portion 32M in the y direction.

It should be noted that configurations other than the above are substantially the same as those of the first embodiment. Hence, the same or corresponding elements are given the same reference characters and are not described repeatedly.

The present embodiment provides an effect similar to that of the first embodiment.

Further, by moving, using supporting rail driving portion 30, rail movable portion 31M supporting door 22, door 22 can be moved in the y direction. In this way, door 22 can be put on opening 21.

Further, door driving portion 51 allows door 22 to move in the x direction to come closer to or go farther away from opening 21. Thus, door 22 can be fully opened in the field of view parallel to opening 21 (Fig. 4).

Further, door driving portion 51 is attached to door 22 to render a position of door 22 free in the y direction. Accordingly, movement of door 22 in the y direction is not prevented by door driving portion 51.

Further, the movement of door 22 is regulated also by guide rail 32. This prevents door 22 from being inclined relative to supporting rail 31.

It should be noted that in each of the embodiments described above, the members fixed to floor FL do not necessarily need to be connected to floor FL, and may be fixed so as not to change their relative positions to floor FL. More specifically, the members fixed to floor FL may be fixed to floor FL using, for example, a frame for use in fixing.

### (Third Embodiment)

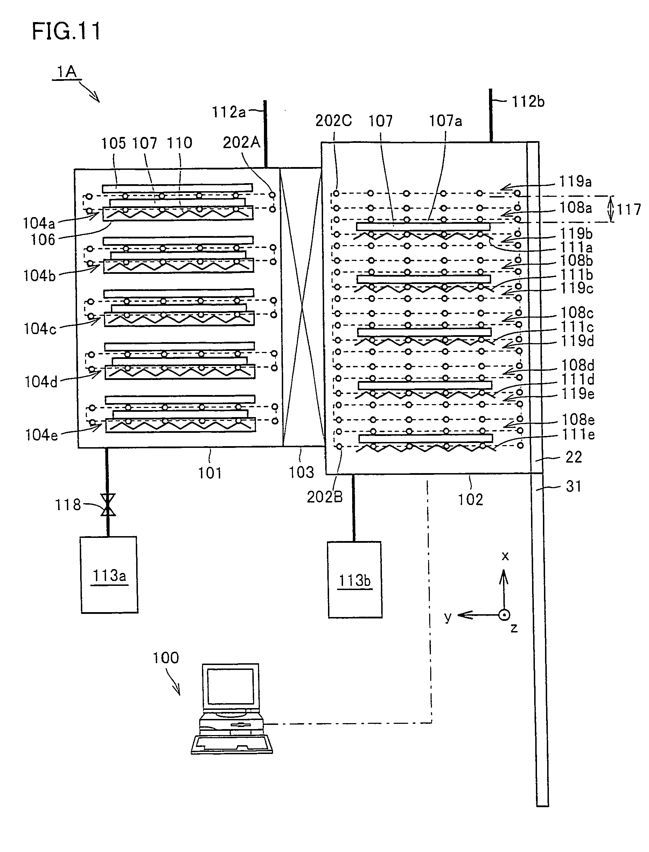

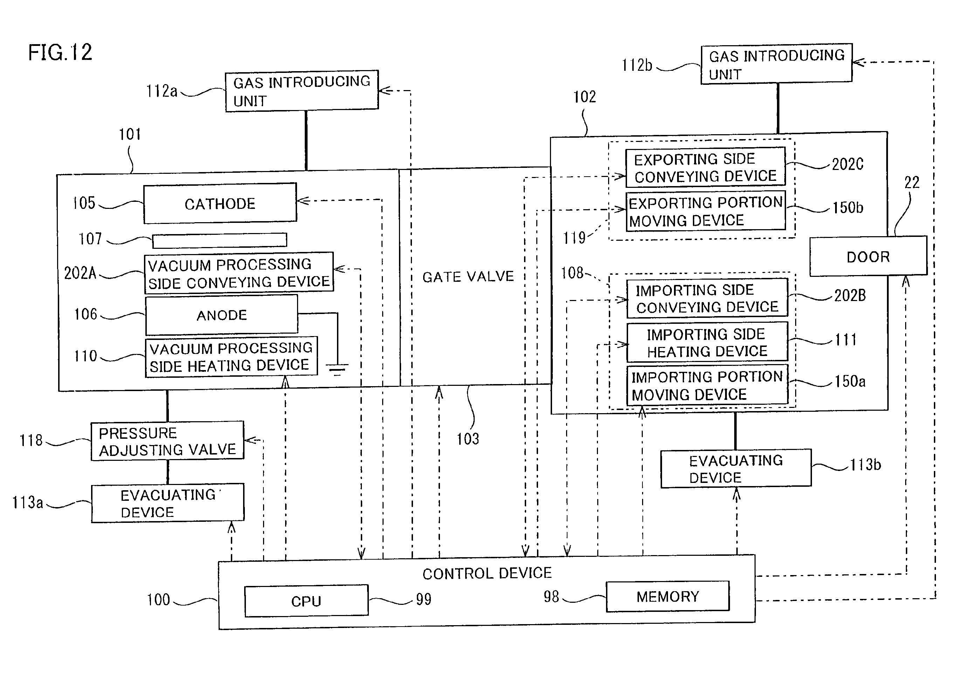

Referring to Fig. 11 and Fig. 12, a vacuum processing device 1A (vacuum device) includes: a vacuum processing chamber 101 in which a vacuum process is performed; a preliminary vacuum chamber 102 (vacuum chamber) used as a load lock chamber; and a gate valve 103 connecting vacuum processing chamber 101 and preliminary vacuum chamber 102 to each other. Vacuum processing chamber 101 is connected to an evacuating device 113a for exhausting gas from within vacuum processing chamber 101. Similarly, preliminary vacuum chamber 102 is connected to an evacuating device 113b for exhausting gas from within preliminary vacuum chamber 102. Each of evacuating devices 113a, 113b is, for example, a vacuum pump.

In vacuum processing chamber 101, there are provided a plurality of electrode pairs each having an electrode structure of parallel plate type. Each of the electrode pairs has a cathode electrode 105 and an anode electrode 106. The plurality of electrode pairs respectively constitute vacuum processing units 104a-104e (also collectively indicated by 104) for processing workpieces 107. Cathode electrode 105 is connected to a power source (not shown) for supplying AC power. Anode electrode 106 is grounded. Each of workpieces 107 is placed in parallel with anode electrode 106. A vacuum processing side heating device 110 is provided in anode electrode 106 of each vacuum processing unit 104, so as to heat workpiece 107. Vacuum processing side heating device 110 is, for example, a heater employing heat generated by a resistor, or a lamp heater. It should be noted that vacuum processing side heating device 110 does not necessarily need to be in one piece with anode electrode 106, and may be provided separately from anode electrode 106.

Further, vacuum processing chamber 101 is provided with a gas introducing unit 112a for introducing a gas used in vacuum processing such as plasma processing. Between evacuating device 113a and vacuum processing chamber 101, a pressure adjusting valve 118 is provided to maintain pressure of the gas, which has been introduced from gas introducing unit 112a, at a constant pressure in vacuum processing chamber 101.

In the present embodiment, workpiece 107 is plasma-processed (vacuum-processed) using plasma generated between cathode electrode 105 and anode electrode 106. More specifically, as the vacuum processing, a film forming process is performed using plasma CVD (Chemical Vapor Deposition).

In preliminary vacuum chamber 102, importing portions 108a-108e (also collectively indicated by 108) are provided. Importing portions 108a-108e respectively include heaters (importing side heating devices) 111a-111e (also collectively indicated by 111) for preliminarily heating workpieces 107. On each of importing portions 108, a workpiece 107 to be vacuum-processed in vacuum processing chamber 101 is disposed. Further, in preliminary vacuum chamber 102, exporting portions 119a-119e (also collectively indicated by 119) are provided to accommodate therein workpieces 107 having been vacuum-processed in vacuum processing chamber 101. Importing portions 108a-108e are respectively disposed distant away from exporting portions 119a-119e by a predetermined distance 117 in direction x (vertical direction in Fig. 11 and also referred to as "direction of arrangement") perpendicular to direction y in which workpiece 107 is conveyed. Further, they are also configured to be movable in direction x of arrangement by predetermined distance 117.

Each of importing portions 108 and exporting portions 119 may be configured to be movable independently in the x direction using an importing portion moving device 150a and an exporting portion moving device 150b (Fig. 12). Alternatively, importing portions 108 and exporting portions 119 may be configured to move altogether in the x direction. For simplicity of the device configuration of vacuum processing device 1A, a preferable configuration is such that importing portion moving device 150a and exporting portion moving device 150b operate cooperatively to move importing portions 108 and exporting portions 119 altogether. To achieve this, there may be provided a frame for supporting importing portions 108 and exporting portions 119 altogether, and a rail for sliding this frame in the x direction.

In the present embodiment, the direction of movement of each importing portion 108 and each exporting portion 119 is the x direction, but the direction of movement is not limited to the x direction. The direction of movement may be any direction as long as importing portion 108 and exporting portion 119 can be moved to a location in which a workpiece 107 can be provided to and from a below-described conveying device 202A of vacuum processing unit 104. Specifically, they may be configured such that by arranging importing portions 108 and exporting portions 119 in a direction including at least one component of the x direction and the z direction, importing portion 108 and exporting portion 119 can be moved in the direction in which they are arranged.

Further, in the present embodiment, importing portions 108a-108e, exporting portions 119a-119e, and vacuum processing units 104a-104e are arranged in the x direction as shown in Fig. 11, but this direction of arrangement may be the z direction, for example.

Preliminary vacuum chamber 102 is provided with a gas introducing unit 112b for gradually introducing a gas for leakage to release atmosphere from within preliminary vacuum chamber 102. Preliminary vacuum chamber 102 has an outer wall provided with an opening, door 22, and supporting rail 31 so as to take in and out workpieces 107 from and to outside. The opening is parallel to the zx plane. Door 22 is to open and close this opening. Supporting rail 31 is to support door 22. Door 22 and supporting rail 31 have configurations substantially the same as those in the first embodiment.

In the present embodiment, door 22 is positioned and sized to allow an operator or the like to take in and out workpieces 107 to and from importing portions 108 and exporting portions 119 without moving importing portions 108 and exporting portions 119. Specifically, door 22 has a larger length in the z direction than that of each workpiece in the z direction. Moreover, door 22 has a larger length in the x direction than that of a region including importing portions 108 and exporting portions 119 in the x direction. In this way, the size of the opening can be large to such an extent that the operator or the like can access all the importing portions 108 and exporting portions. Hence, after placing a workpiece 107 onto an importing portion 108, workpiece 107 can be taken out from an exporting portion 119 without moving importing portion 108 and exporting portion 119.

To satisfy the requirements described above, door 22 should be large to a certain extent. Further, such a large door needs to be thick in thickness to a certain extent to have a strength that allows door 22 to withstand atmospheric pressure. Also, door 22 needs to be made of a material having a large strength. Door 22 has a size larger than 1000 × 1000 mm, for example. Door 22 has a thickness more than 20 mm, for example. Further, an exemplary material usable for the material of door 22 is an aluminum alloy or steel. An example of the steel usable is stainless steel. Such a door 22 can have a weight of, for example, 50 kg or greater, in some case, 100 kg or greater, or 200 kg or greater.

It should be noted that when the size of door 22 is larger, the length of supporting rail 31 becomes longer. For example, supporting rail 31 has a length of, for example, 1000 mm or greater. Supporting rail 31 can be made of a material such as an aluminum alloy, a copper alloy, or steel. An example of the steel usable is stainless steel.

Gate valve 103 provided between vacuum processing chamber 101 and preliminary vacuum chamber 102 can be opened and closed. By opening gate valve 103, the inside of vacuum processing chamber 101 and the inside of preliminary vacuum chamber 102 can be communicated with each other. In this way, while keeping the vacuum state, workpieces 107 can be conveyed between vacuum processing chamber 101 and preliminary vacuum chamber 102.

A conveying mechanism is provided in vacuum processing chamber 101 and preliminary vacuum chamber 102. Such a conveying mechanism may be provided in one of vacuum processing chamber 101 and preliminary vacuum chamber 102, or may be provided in both vacuum processing chamber 101 and preliminary vacuum chamber 102, as long as workpieces 107 can be conveyed from importing portions 108 to vacuum processing units 104 and from vacuum processing units 104 to exporting portions 119.

In the present embodiment, importing portions 108 and exporting portions 119 are movable in their relative direction (direction x of arrangement), and are configured such that vacuum processing units 104 and importing portions 108 as well as vacuum processing units 104 and exporting portions 119 can be arranged in straight lines in direction y in which workpieces 107 are conveyed. In other words, as described above, vacuum processing device 1A has moving means for importing portions 108 and exporting portions 119, and is configured to be capable of conveying workpieces 107 linearly using the conveying mechanism.

Referring to Fig. 12-Fig. 14, the conveying mechanism of vacuum processing device 1A (Fig. 11) has an importing side conveying device 202B provided in each importing portion 108, an exporting side conveying device 202C provided in each exporting portion 119, and a vacuum processing side conveying device 202A provided in each vacuum processing unit 104. Conveying devices 202A, 202B, and 202C have a function of-moving workpieces 107 and retaining them, and are configured in substantially the same way. Hence, the following describes vacuum processing side conveying device 202A.

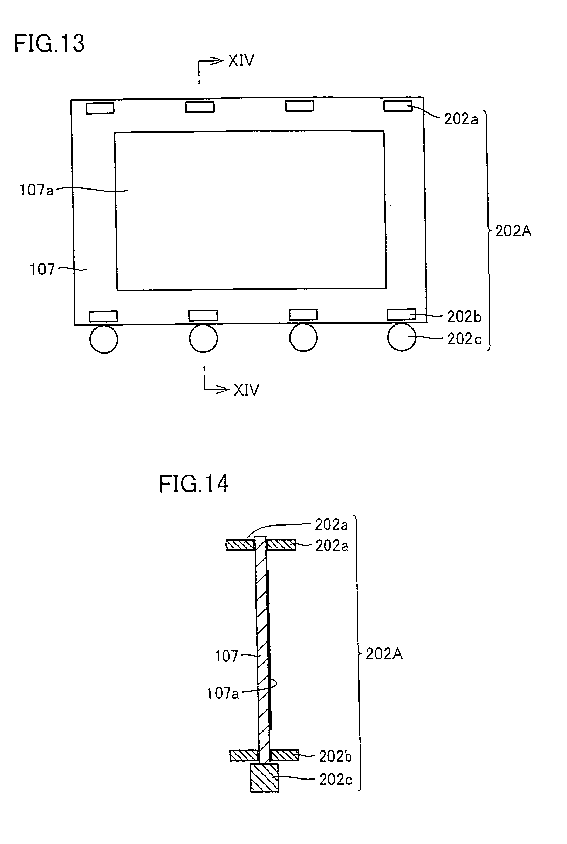

As shown in Fig. 13 and Fig. 14, a workpiece 107 is placed on drive rollers 202c each having a rotating shaft extending in the horizontal direction. Workpiece 107 is supported from lateral sides by follower rollers 202a and follower rollers 202b. Drive rollers 202c are driven by a motor or the like, and moves workpiece 107 linearly in conveying direction y.

According to this configuration, vacuum processing device 1A of the present embodiment can convey a workpiece 107, which is to be subjected to vacuum processing, to vacuum processing unit 104, can provide the vacuum processing to processing target surface 107a, and can convey workpiece 107 thus having been through the vacuum processing to exporting portion 119. Specifically, conveying device 202B of importing portion 108 and conveying device 202A of vacuum processing unit 104 convey a workpiece 107, which is to be subjected to vacuum processing, from an importing portion 108 to a vacuum processing unit 104, and conveying device 202A of vacuum processing unit 104 and conveying device 202C of exporting portion 119 convey workpiece 107 having been through the vacuum processing, from vacuum processing unit 104 to exporting portion 119. When moving workpiece 107 linearly in conveying direction y, such follower rollers 202a, 202b, guides, rails, or grooves can be utilized. In other words, there can be employed a conveying system with a simple configuration to provide driving force to workpiece 107 using a motor or the like.

In the present embodiment, workpiece 107 is placed such that its processing target surface 107a is parallel to the yz plane, but workpiece 107 may be held at any angle as described above.

The following describes a vacuum processing method using vacuum processing device 1A. It should be noted that each device included in vacuum processing device 1A is connected to a control device 100 (Fig. 12) via a cable or an interface. Steps described below are performed mainly by operations of control device 100.

Specifically, control device 100 includes a memory 98 for storing a program therein for controlling vacuum processing device 1A, and a CPU 99 for reading the program to control vacuum processing device 1A. In the present embodiment, the vacuum processing performed by vacuum processing device 1A is controlled by software executed on control device 100.

<Workpiece Placing Step> First, control device 100 opens gas introducing unit 112b to introduce nitrogen gas to preliminary vacuum chamber 102. When atmosphere in preliminary vacuum chamber 102 becomes atmospheric pressure, door 22 is opened to release the atmosphere from within preliminary vacuum chamber 102. In this state, a workpiece 107 to be subjected to vacuum processing is disposed on an importing portion 108. Then, door 22 is closed tightly.

<Heating Step> Next, evacuating device 113b evacuates preliminary vacuum chamber 102. Further, heater 111 is powered on to heat workpiece 107.

<Workpiece Importing Step> After the temperature of workpiece 107 reaches a predetermined temperature and a degree of vacuum in preliminary vacuum chamber 102 reaches a predetermined degree of vacuum, gate valve 103 is opened. Then, workpiece 107 to be subjected to vacuum processing is conveyed from importing portion 108 in preliminary vacuum chamber 102 to vacuum processing unit 104 in vacuum processing chamber 101, using the conveying mechanism. After workpiece 107 is conveyed to vacuum processing unit 104, heater 111 is powered off and gate valve 103 is closed. Here, it is assumed that importing portion 108 may be moved at any timing to a predetermined location (location in which importing portion 108 and vacuum processing unit 104 are arranged in a straight line) for conveying workpiece 107, specifically, importing portion 108 may be moved before opening gate valve 103, after opening gate valve 103, or while gate valve 103 is opened.

<Vacuum Processing Step> Control device 100 causes a film to be formed on workpiece 107 thus conveyed to vacuum processing unit 104, by means of the plasma CVD method. Vacuum processing side heating device 110 in vacuum processing chamber 101 is always powered on during the operation of vacuum processing device 1A, and is controlled by control device 100 to maintain the temperature of workpiece 107 at, for example, 170°C.

Specifically, when gate valve 103 is closed, a reactant gas including a hydrogen gas and a silane gas is introduced into vacuum processing chamber 101 from gas introducing unit 112a. Pressure adjusting valve 118 adjusts the pressure of vacuum processing chamber 101 at a predetermined pressure. Next, when cathode electrode 105 is supplied with a high-frequency power (for example, a frequency of 13.56 MHz), a plasma is generated between cathode electrode 105 and anode electrode 106. This plasma decomposes the reactant gas to form a silicon film on workpiece 107. After the silicon film with a desired film thickness is formed, control device 100 stops the supply of power to cathode electrode 105. Control device 100 stops the introduction of the reactant gas, and causes evacuation of vacuum processing chamber 101.

<Workpiece Placing Step> Meanwhile, during the formation of the film in vacuum processing chamber 101, control device 100 causes introduction of nitrogen gas from gas introducing unit 112b to preliminary vacuum chamber 102 when the temperature of exporting portion 119 goes below the predetermined temperature in preliminary vacuum chamber 102. After the pressure of preliminary vacuum chamber 102 becomes the atmospheric pressure, door 22 is opened to release the atmosphere from within preliminary vacuum chamber 102. When a new workpiece 107 to be subjected to vacuum processing is placed on importing portion 108, door 22 is closed tightly.

Here, the workpiece placing step, the heating step, and the importing portion/exporting portion moving step (these steps are collectively referred to as "placing step") are performed in parallel while the vacuum processing step is performed.

<Heating Step> Next, control device 100 operates evacuating device 113b to start evacuation of preliminary vacuum chamber 102. Then, control device 100 turns on heater 111 to heat workpiece 107 to be subjected to vacuum processing.

<Importing Portion/Exporting Portion Moving Step> Next, importing portion 108 and exporting portion 119 are moved in the x direction by predetermined distance 117 to linearly convey workpiece 107, which has been vacuum-processed in the previous step, from vacuum processing unit 104 to exporting portion 119 in conveying direction y. Namely, control device 100 causes vacuum processing unit 104 and exporting portion 119 to be arranged on an axial line in conveying direction y. It should be noted that this step may be performed after the workpiece placing step, or may be performed while heater 111 heats workpiece 107.

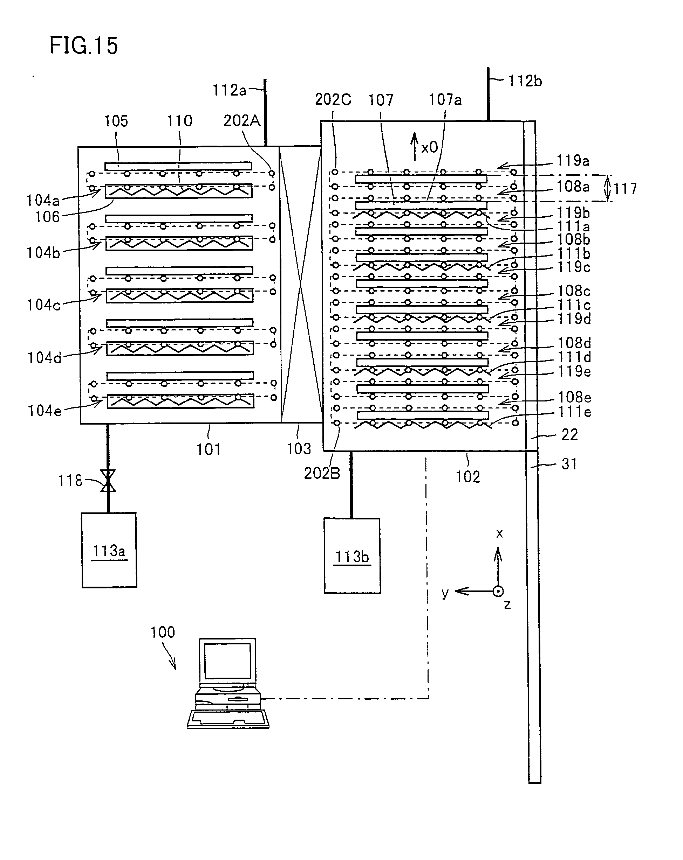

<Workpiece Exporting Step> Gate valve 103 is opened after the temperature of workpiece 107 to be subjected to vacuum processing reaches a predetermined temperature in preliminary vacuum chamber 102, the degree of vacuum in preliminary vacuum chamber 102 reaches a predetermined degree of vacuum, the vacuum processing step has ended in vacuum processing chamber 101, and the pressure in vacuum processing chamber 101 reaches a desired pressure. Next, workpiece 107 having been vacuum-processed is linearly exported from vacuum processing unit 104 to exporting portion 119, using conveying device 202C and conveying device 202B (Fig. 15).

<Importing Portion/Exporting Portion Moving Step> Next, control device 100 operates importing portion moving device 150a and exporting portion moving device 150b to move importing portion 108 and exporting portion 119 in a direction x0 (Fig. 15) by predetermined distance 117 in order to allow conveying device 202B to linearly move workpiece 107, which is accommodated in importing portion 108 and to be vacuum-processed, to vacuum processing unit 104, i.e., in order to arrange importing portion 108 and vacuum processing unit 104 on the axial line.

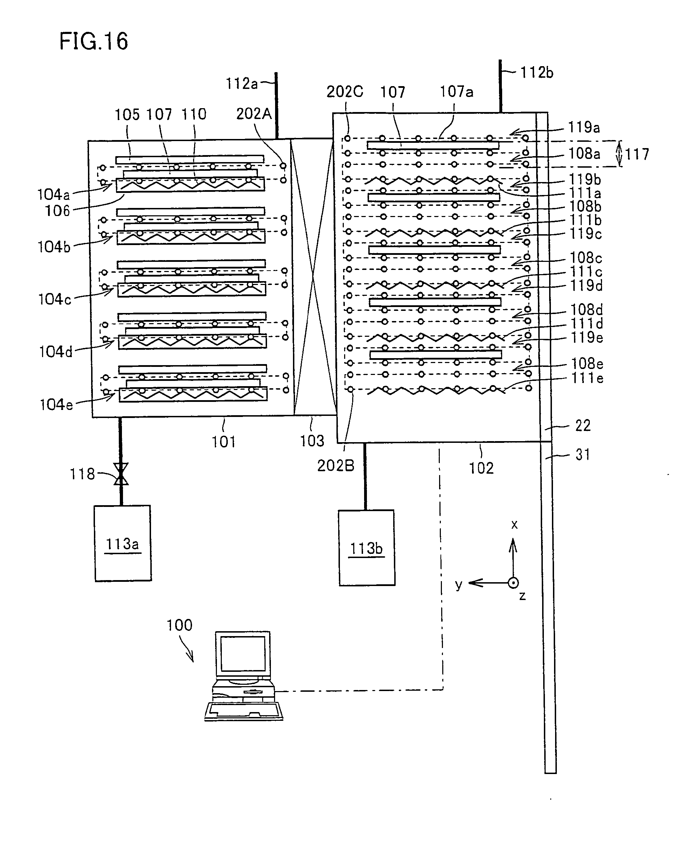

<Workpiece Importing Step> Next, vacuum processing side conveying device 202A and importing side conveying device 202B linearly convey workpiece 107 to be vacuum-processed, from importing portion 108 to vacuum processing unit 104 (Fig. 16). Workpiece 107 to be vacuum-processed is imported into vacuum processing unit 104, and thereafter gate valve 103 is closed tightly and heater 111 is powered off.

<Vacuum Processing Step> As described above, by means of the plasma CVD method, a silicon film is formed on workpiece 107 thus imported into vacuum processing unit 104 and having not been subjected to vacuum processing yet. In this vacuum processing step, the same process as described in the foregoing vacuum processing step is performed. While performing this step, the below-described workpiece removing step, importing portion/exporting portion moving step, workpiece placing step, heating step, and importing portion/exporting portion moving step are performed in parallel.

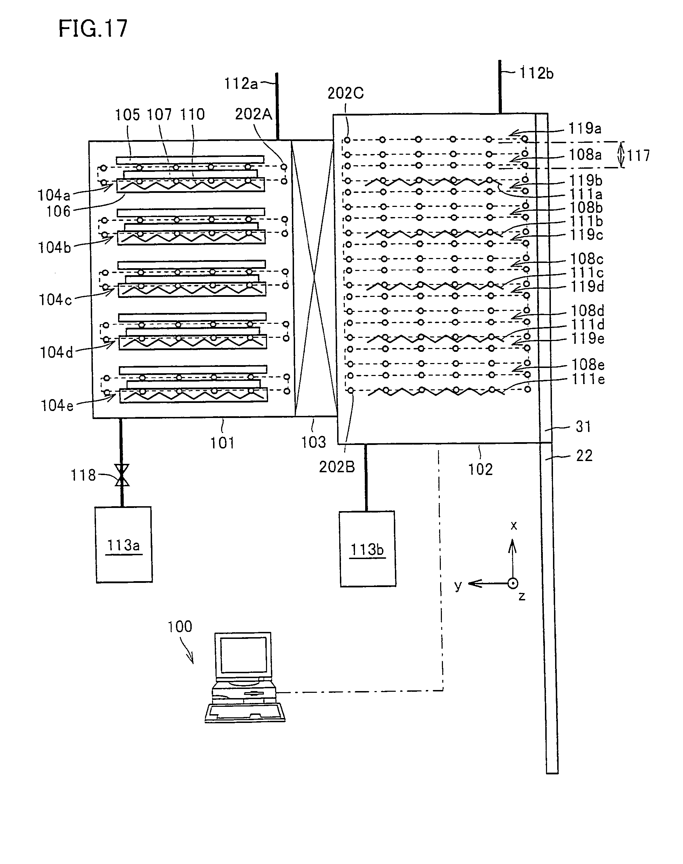

<Workpiece Removing Step> After the temperature of workpiece 107 having been processed and exported to preliminary vacuum chamber 102 is decreased to a predetermined temperature, nitrogen gas is introduced from gas introducing unit 112b into preliminary vacuum chamber 102. When atmosphere in preliminary vacuum chamber 102 becomes substantially as high as the atmospheric pressure, door 22 is opened to release the atmosphere from within preliminary vacuum chamber 102. Then, workpiece 107 processed is removed from exporting portion 119 (Fig. 17).

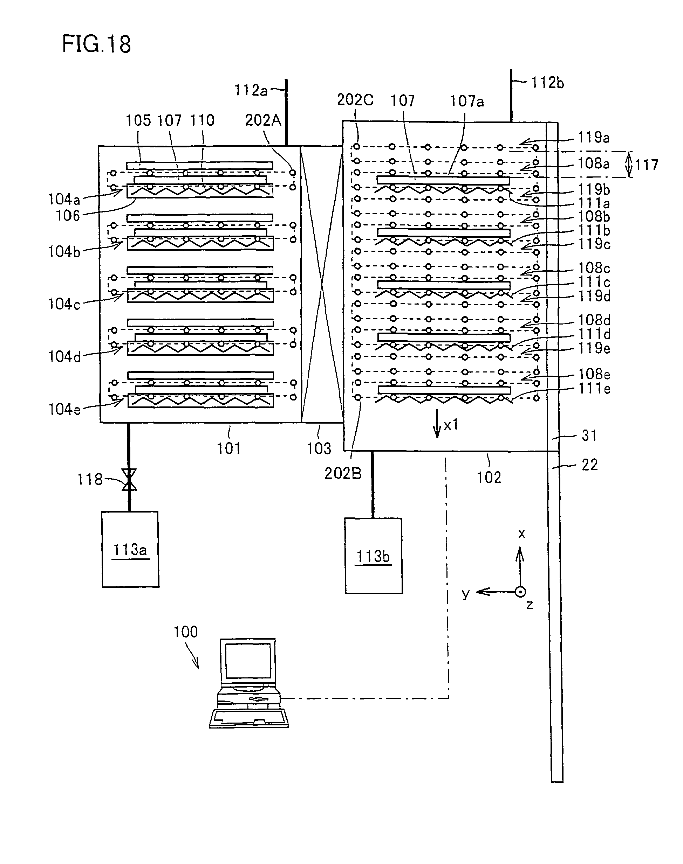

<Workpiece Placing Step> Then, a new workpiece 107 to be vacuum-processed is placed on importing portion 108 (Fig. 18). Then, door 22 is closed tightly.

<Heating Step> Next, control device 100 starts evacuation of preliminary vacuum chamber 102. Then, control device 100 turns on heater 111 to heat workpiece 107, which is to be subjected to vacuum processing, in importing portion 108.

<Importing Portion/Exporting Portion Moving Step> Next, in order to linearly expert, from vacuum processing unit 104 to exporting portion 119, workpiece 107 having been processed, importing portion moving device 150a and exporting portion moving device 150b are operated to move importing portion 108 and exporting portion 119 in a direction x1 (Fig. 18). Namely, control device 100 causes vacuum processing unit 104 and exporting portion 119 to be arranged on the axial line in conveying direction y (Fig. 11).

Thereafter, control device 100 repeats the steps from the above-described workpiece exporting step to the importing portion/exporting portion moving step. By performing the series of steps, workpieces 107 can be taken in and taken out efficiently. In addition, during the vacuum processing step, a workpiece 107 having been subjected to vacuum processing can be cooled down and a workpiece 107 to be subjected to vacuum processing can be heated. Accordingly, tact time (operation time necessary for one workpiece 107) for vacuum processing device 1A can be shortened.

Moreover, according to the present embodiment, door 22 has a larger length in the x direction than that of the region including importing portions 108 and exporting portions 119 in the x direction as shown in Fig. 11. In this way, the size of the opening can be large to such an extent that an operator or the like can access all the importing portions 108 and exporting portions. Hence, without moving importing portions 108a-108e and exporting portions 119a-119e, workpieces 107 can be provided from outside preliminary vacuum chamber 102 to importing portions 108a-108e and workpieces 107 held by exporting portions 119a-119e can be taken out of preliminary vacuum chamber 102.

In the case where door 22 is longer in the x direction than the region including importing portions 108 and exporting portions 119 as described above, door 22 becomes large in size and therefore large in weight. In the present embodiment, door 22 thus having a large weight is stably supported by supporting rail 31 as with the first embodiment. However, door 22 and the mechanism that supports door 22 are not limited to the configurations of the first embodiment, and may be configured as in the second embodiment, for example.

It should be noted that in the present embodiment, importing portions 108 and exporting portions 119 are provided, but a portion serving both as each importing portion 108 and each exporting portion 119 may be provided if a longer tact time is permitted. Further, heaters 111a-111e may not be provided. Furthermore, the conveying mechanism may not be provided inside the vacuum device. Moreover, in the present embodiment, as the vacuum processing, the film forming processing is performed using the plasma CVD, but the vacuum processing is not limited to this. The vacuum processing may be, for example, film forming processing using a sputtering method or a vapor deposition method, or plasma etching processing.

### (Fourth Embodiment)

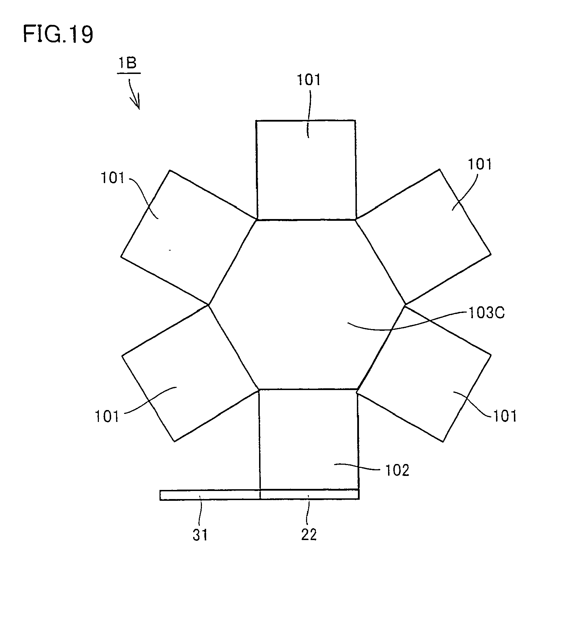

Referring to Fig. 19 mainly, a vacuum device 1B of the present embodiment has a plurality of vacuum processing chambers 101 (multi-chamber), a conveying chamber 103C, a preliminary vacuum chamber 102, a door 22, and a supporting rail 31. Although one vacuum processing chamber 101 is provided in the third embodiment, in the present embodiment, the plurality of vacuum processing chambers 101 are provided. Conveying chamber 103C is configured to be capable of conveying a workpiece 107 between each of the plurality of vacuum processing chambers 101 and preliminary vacuum chamber 102. For example, this conveying chamber 103C is configured to include a mechanism for turning around a workpiece 107 in order to convey workpiece 107 between preliminary vacuum chamber 102 and a specific vacuum processing chamber 101. It should be noted that because conveying chamber 107 is provided in the present embodiment, importing portion moving device 150a and exporting portion moving device 150b may not be provided.

It should be noted that configurations other than the above are substantially the same as those of the third embodiment. Hence, the same or corresponding elements are given the same reference characters and are not described repeatedly.

The embodiments disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

The present invention is particularly advantageously applicable to a vacuum device having a vacuum chamber.

### DESCRIPTION OF THE REFERENCE SIGNS

1A: vacuum processing device (vacuum device); 20: vacuum chamber; 21: opening; 22: door; 30: supporting rail driving portion; 30A: main body portion; 30B: rod; 31: supporting rail; 31F: supporting rail fixing portion; 31M: supporting rail movable portion; 32: guide rail; 32F: guide rail fixing portion; 32M: guide rail movable portion; 41: wheel; 42: roller; 51: door driving portion; 51A: displacement portion; 51B: raceway portion; 51C: holding portion; 51D: projection; 52: guide rail driving portion; 52A: main body portion; 52B: rod; 61: O ring; 101: vacuum processing chamber; 102: preliminary vacuum chamber (vacuum chamber); 103: gate valve; 103C: conveying chamber; 104, 104a-104e: vacuum processing unit; 107: workpiece; 107a: processing target surface; 108, 108a-108e: importing portion; 111, 111a-111e: heater; 119, 119a-119e: exporting portion; FL: floor; T: taper portion.

## Claims

1. A vacuum device comprising:
a vacuum chamber (20) having an opening;
a door (22) for closing said opening; and
a first rail (31) extending in a first direction (X) with a space between said first rail and said opening when viewed in a planar view, supporting said door to be movable in said first direction, and having a portion facing said opening in a second direction (Y) crossing said first direction when viewed in a planar view,
said first rail having a first movable portion (31M) movable in said second direction.

2. The vacuum device according to claim 1, wherein each of said first and second directions crosses a direction of gravity (Z).

3. The vacuum device according to claim 1 or 2, further comprising a first driving portion (30) for moving said first movable portion.

4. The vacuum device according to any one of claims 1-3, further comprising a second driving portion (51) for moving said door in said first direction.

5. The vacuum device according to claim 4, wherein said second driving portion is attached to said door to define a position of said door in said first direction and to render a position of said door free in said second direction.

6. The vacuum device according to any one of claims 1-5, wherein:
said first rail has a taper portion (T) tapered upward to have a size in said second direction getting smaller toward its tip, and
said door has a portion (41) sandwiching said taper portion in said second direction.

7. The vacuum device according to any one of claims 1-6, further comprising:
a second rail (32) extending in said first direction with a space between said second rail and said opening when viewed in a planar view, having a portion facing said opening in said second direction when viewed in a planar view, and guiding said door in said first direction, wherein
said second rail has a second movable portion (32M) movable in said second direction.

8. The vacuum device according to any one of claims 1-7, wherein:
said vacuum device is to handle a plurality of workpieces collectively, and
said vacuum chamber has a plurality of regions for disposing said plurality of workpieces therein.

9. The vacuum device according to claim 8, wherein:
said plurality of regions are arranged in one direction for one length, and
said door has a length larger than said one length in said one direction.
